# EUROPEAN PATENT APPLICATION

(11) **EP 4 842 155 A1**
(43) Date of publication of application: **18.11.2026**
(21) Application number: 25214825.9
(22) Date of filing: 11.11.2025
(51) Int. Cl.: H10B 12/00, H10D 1/68, H10D 30/01, H10D 84/80

(54) **MEMORY CELL INCLUDING TRANSISTOR AND WORD LINE-COUPLED MULTI- LAYER STACK HAVING ON-SOURCE FERROELECTRIC CAPACITOR SECTION AND ON-CHANNEL GATE SECTION**

(30) Priority: 12.05.2025 US 202519205643
(71) Applicant: GlobalFoundries Dresden Module One Limited Liability Company & Co. KG, 01109 Dresden (DE)
(72) Inventor: MÜLLER, Johannes, Dresden (DE); DÜNKEL, Stefan, Dresden (DE); KLEIMAIER, Dominik Martin, Dresden (DE); MULAOSMANOVIC, Halid, Dresden (DE)
(74) Representative: Grünecker Patent- und Rechtsanwälte PartG mbB

(57) **Abstract**

A disclosed memory cell includes a transistor (110) with a channel region (113) in a substrate between source (111) and drain (112) regions. A multi-layer stack on the substrate includes: a first section (including a ferroelectric capacitor (FEC)) adjacent the source region and a second section (including the transistor gate) adjacent the channel region. Specifically, the multi-layer stack includes: a first metallic layer (161) on the source region in the first section; a first insulating layer (151) on the channel region in the second section; a second insulating layer (152) on the first metallic layer and the first insulating layer; and a second metallic layer (162) on the second insulating layer. In some embodiments, the second insulating layer is FE material and the multi-layer stack also includes third insulating (153) and metallic (163) layers on the second metallic layer in the first and second sections. Also disclosed are methods for operating and for forming the memory cell.

## Description

### BACKGROUND

The present disclosure relates to non-volatile memory (NVM) cells and, more particularly, to embodiments of a robust ferroelectric material (FEM)-based NVM cell, to embodiments of a NVM cell operating method, and to embodiments of a NVM cell forming method.

FEM-based NVM cells include, for example, ferroelectric capacitors (FECs) and ferroelectric field effect transistors (FEFETs). A typical FEC includes an FEM layer between two metal layers. Write operations including programming and erasing operations can be directed to an FEC to store a first logic value or a second logic value (e.g., a "1" or a "0") therein by switching the direction of polarization of the FEM layer and thereby the capacitance of the FEC. A read operation can be directed to the FEC to read the stored data therein. While these FECs are robust (e.g., they can endure over 1*10¹² write cycles), each read operation is destructive (i.e., switches the stored data value). A typical FEFET includes source/drain regions, a channel region between the source/drain regions, and a gate structure adjacent to the channel region. The gate structure is a metal-ferroelectric-insulator (MFI) gate structure. That is, the gate structure includes an insulating interface (IF) layer on the channel region, an FEM layer on the IF layer, and a gate metal layer on the FEM layer. With this MFI-gate structure, write operations including programming and erasing operations can be directed to the FEFET to store a first logic value or a second logic value (e.g., a "1" or a "0") in the FEM layer. Additionally, non-destructive read operations can be directed to the FEFET to read the stored data therein without concurrently switching the logic value. However, FEFETs suffer from low endurance (i.e., they can endure significantly fewer write cycles) due to degradation (e.g., time dependent dielectric breakdown (TDDB)) of the IF layer.

### SUMMARY

Disclosed herein are embodiments of a structure including a robust ferroelectric material-based memory cell. Generally, the structure can include a transistor. The transistor can include: a source region; a drain region; and a channel region between the source region and the drain region. The structure can further include a multi-layer stack. The multi-layer stack can include at least: a first metallic layer on the source region; a first insulating layer on the channel region; a second insulating layer on the first metallic layer and on the first insulating layer; and a second metallic layer on the second insulating layer.

In some embodiments, the structure can include a transistor. The transistor can include: a source region; a drain region; and a channel region between the source region and the drain region. The structure can further include a multi-layer stack with a first section on the source region and with a second section on the channel region. Specifically, the multi-layer stack can include: a first metallic layer on the source region in the first section; a first insulating layer on the channel region in the second section; a second insulating layer on the first metallic layer in the first section and on the first insulating layer in the second section; a second metallic layer on the second insulating layer in the first section and the second section; a third insulating layer on the second metallic layer in the first section and in the second section; and a third metallic layer on the third insulating layer in the first section and in the second section. In these embodiments, the second insulating layer can be a ferroelectric material layer. **In** other embodiments, the structure can include a transistor. The transistor can include: a source region; a drain region; and a channel region between the source region and the drain region. The structure can further include a multi-layer stack with a first section on the source region and with a second section on the channel region. Specifically, the multi-layer stack can include: a first metallic layer on the source region in the first section; a first insulating layer on the channel region in the second section; a second insulating layer on the first metallic layer in the first section and on the first insulating layer in the second section; a second metallic layer on the second insulating layer in the first section and the second section; a third insulating layer on the second metallic layer in the first section only; and a third metallic layer on the third insulating layer in the first section only. **In** these embodiments, the third insulating layer can be a ferroelectric material layer and, as noted above, the second section is devoid of the third insulating layer and the third metallic layer.

Also disclosed herein are method embodiments for forming the disclosed structure. For example, the method can include forming components for a transistor include a source region, a drain region, and a channel region between the source region and the drain region. The method can further include forming a multi-layer stack with a first section on the source region and with a second section on the channel region. Formation of the multi-layer stack can include forming and patterning a first metallic layer and a first insulating layer so that the first metallic layer is on the source region in the first section and so that the first insulating layer is on the channel region in the second section. Formation of the multi-layer stack can further include forming a second insulating layer on the first metallic layer and forming a second metallic layer on the second insulating layer.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1 is a schematic diagram illustrating disclosed embodiments of a structure with a ferroelectric material-based memory cell;
FIGs. 2-5 are cross-section diagrams illustrating different embodiments, respectively, of the structure of FIG. 1;
FIG. 6 is a table illustrating an example of a set of operation-dependent bias voltage conditions that can be employed during operation of the memory cell shown in FIGs. 2, 3, 4, or 5;
FIG. 7 is a table illustrating another example of a set of operation-dependent bias voltage conditions that could be employed during operation of the memory cell shown in FIGs. 2, 3, 4, or 5;
FIG. 8 is a flow diagram illustrating embodiments of methods of forming any of the disclosed structures as shown in FIGs. 2-5;
FIGs. 9-14 are cross-section diagrams illustrating various processes in a method of forming a disclosed structure (e.g., as shown in FIG. 2); and
FIGs. 15-17 are cross-section diagrams illustrating various processes in another method of forming a disclosed structure (e.g., as shown in FIG. 3).

### DETAILED DESCRIPTION

As mentioned above, FEM-based NVM cells include, for example, ferroelectric capacitors (FECs) and ferroelectric field effect transistors (FEFETs). A typical FEC includes an FEM layer between two metal layers. Write operations including programming and erasing operations can be directed to an FEC to store a first logic value or a second logic value (e.g., a "1" or a "0") therein by switching the direction of polarization of the FEM layer and thereby the capacitance of the FEC. A read operation can be directed to the FEC to read the stored data therein. While these FECs are robust (e.g., they can endure over 1*10¹² write cycles), each read operation is destructive (i.e., switches the stored data value). A typical FEFET includes source/drain regions, a channel region between the source/drain regions, and a gate structure adjacent to the channel region. The gate structure is a metal-ferroelectric-insulator (MFI) gate structure. That is, the gate structure includes an insulating interface (IF) layer on the channel region, an FEM layer on the IF layer, and a gate metal layer on the FEM layer. With this MFI-gate structure, write operations including programming and erasing operations can be directed to the FEFET to store a first logic value or a second logic value (e.g., a "1" or a "0") in the FEM layer. Additionally, non-destructive read operations can be directed to the FEFET to read the stored data therein without concurrently switching the logic value. However, FEFETs suffer from low endurance (i.e., they can endure significantly fewer write cycles) due to degradation (e.g., time dependent dielectric breakdown (TDDB)) of the IF layer.

In view of the foregoing, disclosed herein are embodiments of a structure including a robust ferroelectric material (FEM)-based non-volatile memory (NVM) cell (hereinafter referred to as a memory cell), which includes a read transistor and a write ferroelectric capacitor (FEC). Specifically, the memory cell includes a single transistor and a word line-coupled multi-layer stack, which includes an on-source ferroelectric capacitor (FEC) section and an on-channel gate section positioned laterally adjacent to the on-source FEC section. More specifically, the memory cell can include a transistor. The transistor can include a channel region within a substrate between source and drain regions and a gate on the substrate adjacent to the channel region. The memory cell can further include a multi-layer stack on the substrate and coupled to a word line (WL). The multi-layer stack can include a first section (including series capacitors, one of which is an FEC) on the source region and a second section (including the transistor gate) on the channel region and coupled to the FEC. More specifically, the multi-layer stack can include: a first metallic layer above and immediately adjacent to the source region in the first section; a first insulating layer above and immediately adjacent to channel region in the second section; a second insulating layer on the first metallic layer in the first section and on the first insulating layer in the second section; and a second metallic layer on the second insulating layer also in the first and second sections.

In some embodiments, the second insulating layer is made of a ferroelectric material (FEM) and the multi-layer stack also includes, within both the first and second sections, a third insulating layer of a non-ferroelectric material on the second metallic layer and a third metallic layer on the second insulating layer in the first and second sections. In other embodiments, the second insulating layer is a non-ferroelectric material and the multi-layer stack also includes, only within the first section, a third insulating layer made of FEM on the second metallic layer; and a third metallic layer stacked on the third insulating layer. Also disclosed herein are embodiments of a method of operating the disclosed memory cell. As discussed in greater detail below, due to the two-section configuration of the multi-layer stack over the source and channel regions, write operations (including programming and erasing operations) can be performed to store data in the FEC in such a way that limits exposure of the first insulating layer in the transistor gate to high write voltages and read operations can be performed without causing the stored data to flip. Also disclosed herein are embodiments of a method of forming the disclosed memory cell.

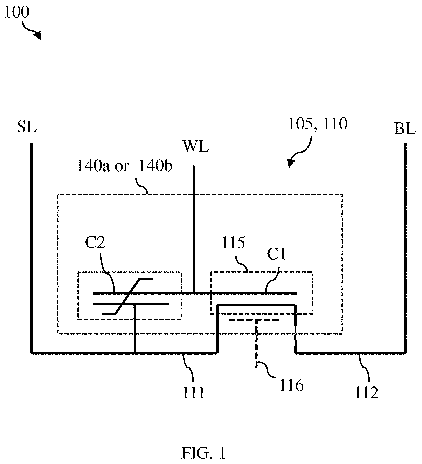

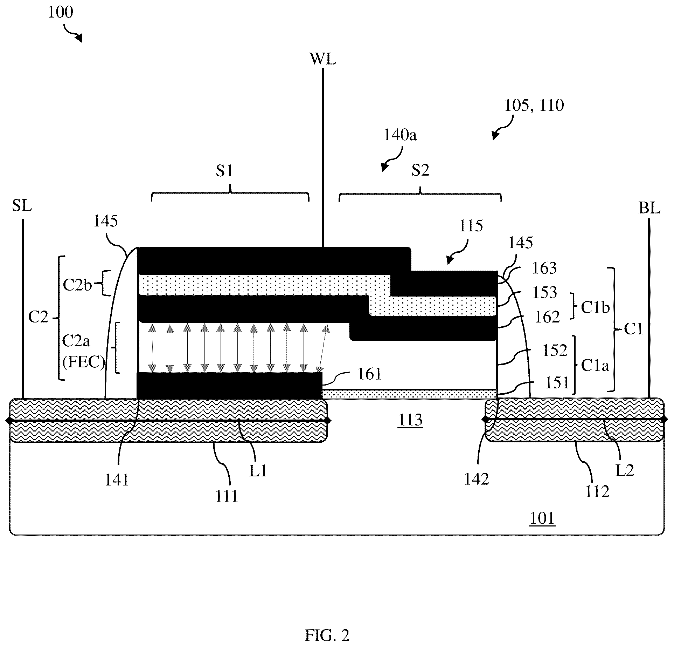

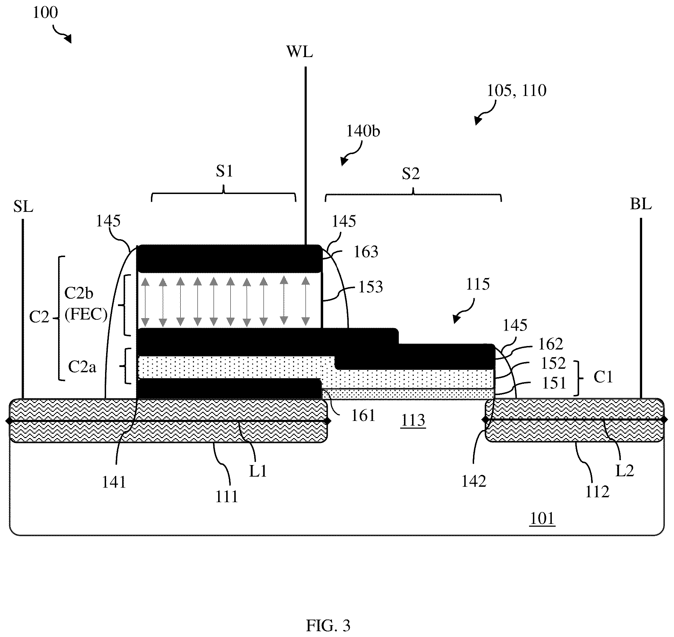

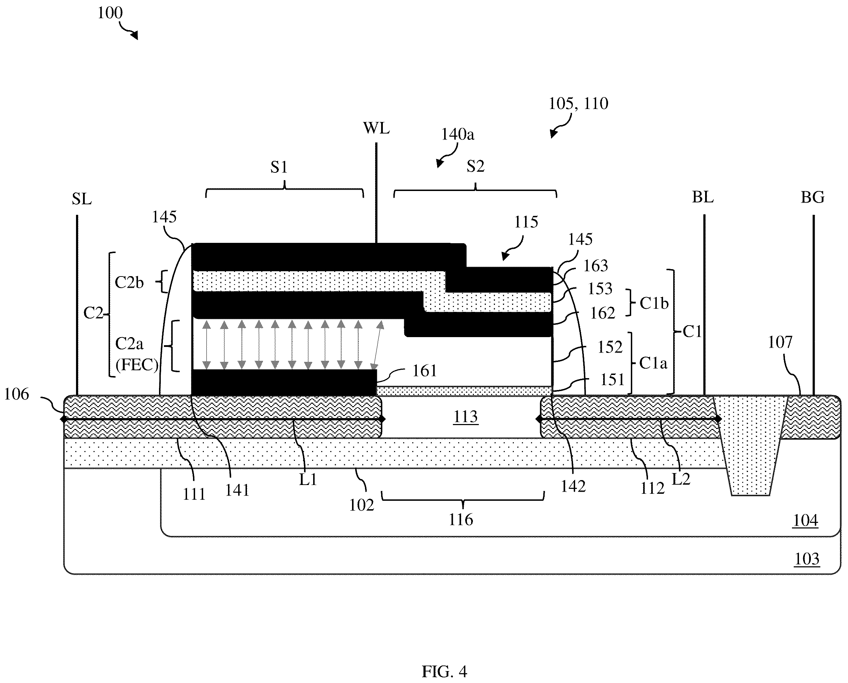

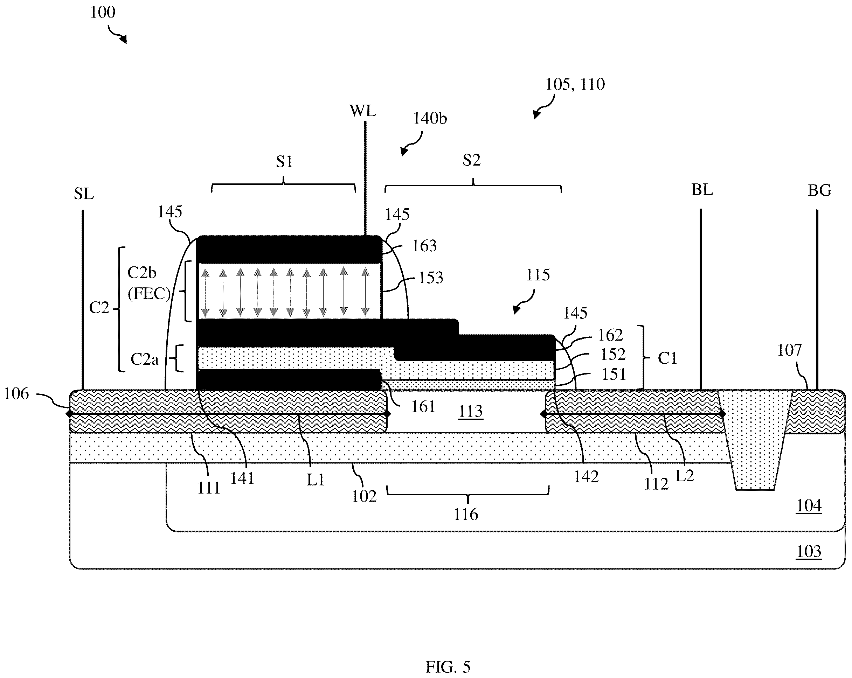

More particularly, FIG. 1 is a schematic diagram illustrating disclosed embodiments of a structure 100, which includes a non-volatile memory (NVM) cell 105 (referred to hereinafter as memory cell 105). FIGs. 2-5 are cross-section diagrams illustrating alternative embodiments of structure 100. Referring to FIGs. 1 and 2-3, structure 100 can include a substrate. The substrate can, for example, be a bulk semiconductor substrate 101 (as illustrated in FIGs. 2 and 3). Bulk semiconductor substrate 101 can be a monocrystalline semiconductor substrate. For example, bulk semiconductor substrate 101 can be a monocrystalline silicon substrate or a monocrystalline substrate of any other suitable semiconductor material (e.g., silicon germanium). Semiconductor substrate 101 can include a bottom surface and a top surface opposite the bottom surface. It should be understood that the figures are not intended to be limiting. Alternatively, structure 100 could include a different type of substrate (e.g., see FIGs. 4 and 5 and discussion thereof below).

Referring to FIGs. 1-3, structure 100 can further include a memory cell 105. Memory cell 105 can include a transistor 110. Transistor 110 can, for example, be an N-type field effect transistor (NFET). For example, semiconductor substrate 101 can be doped so as to have P-type conductivity at a relatively low conductivity level (e.g., to be a P- substrate). Transistor 110 can include a source region 111 and a drain region 112 in semiconductor substrate 101 adjacent to the top surface. Source region 111 and drain region 112 can each be doped so as to have N-type conductivity at a relatively high conductivity level. That is, source region 111 and drain region 112 can be doped so as to be N+ source/drain regions. A channel region 113 (e.g., a P- channel region) can be positioned laterally between source region 111 and drain region 112 at the top surface of semiconductor substrate 101. Source region 111 can be electrically connected to a source line (SL). Drain region 112 can be electrically connected to a BL.

Transistor 110 can further include a gate 115 on the top surface of semiconductor substrate 101 adjacent to channel region 113. However, in the disclosed embodiments, instead of being a discrete structure, gate 115 can be included within one section of a multi-layer stack 140a (see FIG. 2) or 140b (see FIG. 3), which is on the top surface of semiconductor substrate 101 over a portion of source region 111 and also over channel region 113. More particularly, transistor 110 can be an asymmetric transistor. Source region 111 can be relatively long compared to drain region 112. That is, source region 111 can have a first length (L1) and drain region 112 can have a second length (L2) that is less than L1. A multi-layer stack (e.g., see stack 140a of FIG. 2 or stack 140b of FIG. 3) can be on the top surface of semiconductor substrate 101 and can include a first section (S1) (also referred to herein as an on-source section) above and immediately adjacent to source region 111 and a second section (S2) (also referred to as an on-channel section or gate section above and immediately adjacent to channel region 113.

S1 can extend laterally in a first direction from the junction between source region 111 and channel region 113 to a first sidewall 141 above source region 111. S2 of multi-layer stack 140a or 140b can extend laterally in a second direction (opposite the first direction) from the junction between source region 111 and channel region 113 to a second sidewall 142 adjacent the junction between channel region 113 and drain region 112. A portion of source region 111 can further extend laterally in the first direction beyond the first sidewall 141, whereas drain region 112 can extend laterally in the second direction beyond second sidewall 142. As illustrated, dielectric sidewall spacer 145 can be positioned laterally adjacent to first and second sidewalls 141-142.

S1 and S2 can be coupled to a word line (WL). S1 can include multiple insulator and metallic layers stacked to form include series capacitors (also referred to as series-connected capacitors or capacitors electrically connected in series), which include one ferroelectric capacitor (FEC) for data storage, and which are electrically connected at one end by a first metallic layer 161 to source region 111 and at an opposite end to WL by a third metallic layer 163. S2 can include insulator and metallic layers stacked to form gate 115, with a first insulating layer 151 (and particularly an insulating interface (IF) layer) adjacent to channel region 113 and at least one additional insulator layer and one metallic layer stacked above and coupled to WL. Differences between multi-layer stack 140a of FIG. 2 and multi-layer stack 140b of FIG. 3 include, but are not limited to, different locations of FEC within S1 (e.g., at first metallic layer 161 or at third metallic layer 163) and different numbers of layers within S2 (e.g., five or three).

Multi-layer stack 140a and multi-layer stack 140b can each include a first metallic layer 161 within S1 above and immediately adjacent to source region 111. First metallic layer 161 be composed of one or more materials layers selected to form an ohmic contact at the metal-semiconductor junction. Thus, first metallic layer 161 can be, for example, a metal layer (e.g., tungsten, titanium, tantalum, etc.) or a metal alloy layer (e.g., a metal nitride, such as titanium nitride or tantalum nitride, or a metal silicide, such as nickel silicide, tungsten silicide, or some other suitable metal silicide). Alternatively, first metallic layer 161 could be a multi-metallic layer stack suitable for creation of an ohmic contact (e.g., titanium/aluminum/titanium nitride, titanium/aluminum/titanium/gold, or molybdenum/aluminum/molybdenum/gold).

Multi-layer stack 140a and multi-layer stack 140b can each include a first insulating layer 151 within S2 above and immediately adjacent to channel region 113. As illustrated, first insulating layer 151 can be positioned laterally adjacent to first metallic layer 161. Optionally, first insulating layer 151 can be relatively thin compared to first metallic layer 161. First insulating layer 151 can be an insulating interface (IF) layer. Insulating IF layer can, for example, include a silicon dioxide, silicon oxynitride, or another dielectric material with a dielectric constant (K) that is relatively low (e.g., K≤5, such as K~3.9) .

Multi-layer stack 140a and multi-layer stack 140b can each include a second insulating layer 152 covering first metallic layer 161 within S1 and covering first insulating layer 151 within S2. However, the material used for the second insulating layer 152 in multi-layer stack 140a of FIG. 2 can be different from the material used for the second insulating layer 152 in multi-layer stack 140b of FIG. 3.

Specifically, referring to FIG. 2, in multi-layer stack 140a the second insulating layer 152 (which is on first metallic layer 161 in S1 and on the first insulating layer 151 in S2) can specifically be a relatively thick ferroelectric material (FEM) layer. This FEM layer can be, for example, a hafnium oxide-based FEM layer, such as a silicon-doped hafnium oxide layer or a hafnium zirconium oxide layer, or a layer of some other suitable FEM capable of switching polarity in response to an applied electric field. Multi-layer stack 140a also includes a second metallic layer 162 covering second insulating layer 152 within S1 and S2. Second metallic layer 162 can be, for example, a metal layer (e.g., tungsten, titanium, tantalum, etc.) or a metal alloy layer (e.g., a metal nitride, such as titanium nitride or tantalum nitride). As discussed in greater detail below with regard to the operating method, second metallic layer 162 functions as a floating metallic node included in both the FEC of S1 and gate 115 of S2.

Multi-layer stack 140a can also include a third insulating layer 153 covering second metallic layer 162 within S1 and S2. Third insulating layer 153 can specifically be a layer of high-K dielectric material (i.e., a dielectric material where K>3.9 and ideally where K>7 or even higher, such as K>20) that is not ferroelectric. Exemplary high-K dielectric materials include, but are not limited to, silicon nitride, silicon oxynitride, alumina, and non-ferroelectric hafnium oxide. Those skilled in the art will recognize that the ferroelectric properties of hafnium oxide films can depend, for example, on the polymorphic phase of the material and/or material doping.

Multi-layer stack 140a can also include a third metallic layer 163 covering third insulating layer 153 within S1 and S2. Third metallic layer 163 can be, for example, a metal layer (e.g., tungsten, titanium, tantalum, etc.) or a metal alloy layer (e.g., a metal nitride, such as titanium nitride or tantalum nitride). It should be noted that in multi-layer stack 140a the first, second, and third metallic layers 161-163 can all be made of the same metal or metal alloy material or two or more of the metallic layers 161-163 can be made of different metal or metal alloy materials. In any case, third metallic layer 163 can be electrically connected to WL.

Thus, S1 includes series capacitors C2a and C2b. Within S1, C2a includes the portion of second insulating layer 152 between first metallic layer 161 (which is immediately adjacent and thereby electrically connected to source region 111) and second metallic layer 162. Since second insulating layer 152 is made of FEM with switchable polarization, C2a is an FEC capable of exhibiting variable capacitance. Within S1, C2b includes a portion of third insulating layer 153 between second metallic layer 162 and third metallic layer 163 (which is electrically connected to WL). Additionally, S2 includes five layers, which make up gate 115. That is, gate 115 includes: first insulating layer 151 on channel region 113 and portions of second insulating layer 152, second metallic layer 162, third insulating layer 153, and third metallic layer 163 stacked thereon and further electrically connected to WL. Third metallic layer 163 (which extends across both S1 and S2) is connected to WL.

Alternatively, referring to FIG. 3, in multi-layer stack 140b the second insulating layer 152 (which is on first metallic layer 161 in S1 and on first insulating layer 151 in S2) could be a layer of high-K dielectric material (e.g., silicon nitride, silicon oxynitride, alumina, non-ferroelectric hafnium oxide, etc.). Multi-layer stack 140b can also include a second metallic layer 162 on second insulating layer 152 within S1 and S2. Second metallic layer 162 can be, for example, a metal layer (e.g., tungsten, titanium, tantalum, etc.) or a metal alloy layer (e.g., a metal nitride, such as titanium nitride or tantalum nitride). As discussed in greater detail below, second metallic layer 162 functions as a floating metallic node included in both the FEC of S1 and gate 115 of S2.

Multi-layer stack 140b can further include a third insulating layer 153 on the second metallic layer 162, but only within S1. In multi-layer stack 140b, the third insulating layer 153 can specifically be a relatively thick FEM layer. This FEM layer can be, for example, a hafnium oxide-based FEM layer, such as a silicon-doped hafnium oxide layer or a hafnium zirconium oxide layer, or a layer of some other suitable FEM capable of switching polarity in response to an applied electric field. Multi-layer stack 140b can also include a third metallic layer 163 covering third insulating layer 153 and within S1 only. Third metallic layer 163 can be, for example, a metal layer (e.g., tungsten, titanium, tantalum, etc.) or a metal alloy layer (e.g., a metal nitride, such as titanium nitride or tantalum nitride). It should be noted that in multi-layer stack 140b the first, second, and third metallic layers 161-163 can all be made of the same metal or metal alloy material or two or more of the metallic layers 161-163 can be made of different metal or metal alloy materials. In multi-layer stack 140b, third metallic layer 163 can be electrically connected to WL.

Thus, S1 includes series capacitors C2a and C2b. Within S1, C2a includes the portion of second insulating layer 152 between first metallic layer 161 (which is immediately adjacent and thereby electrically connected to source region 111) and second metallic layer 162. C2b includes a portion of third insulating layer 153 between second metallic layer 162 and third metallic layer 163 (which is electrically connected to WL). Since third insulating layer 153 is made of FEM with switchable polarization, C2b is an FEC capable of exhibiting variable capacitance. Additionally, S2 includes only three layers, which make up gate 115. That is, gate 115 includes: first insulating layer 151 on channel region 113 and portions of second insulating layer 152 and second metallic layer 162 stacked thereon and electrically coupled to WL through C2b.

As discussed in greater detail below with regard to the disclosed operating methods. In memory cell 105, a write operation can be performed to store a logic value within the FEC of S1 of memory cell 105 by applying specific write (e.g., program or erase) bias conditions on the three terminals of transistor 110 (i.e., source region 111, drain region 112, and gate 115) through WL, BL, and SL without also degrading first insulating layer 151 of gate 115 in S2. Additionally, in memory cell 105, a read operation can be performed to read out a stored logic value from the FEC of S2 by applying specific read bias conditions on the three terminals through WL, BL, and SL without also destroying (i.e., flipping) the stored data.

The embodiments of structure 100 described above and illustrated in FIGs. 2 and 3 includes a bulk semiconductor substrate 101. However, in alternative embodiments, structure 100 could instead include a semiconductor-on-insulator substrate. For example, referring to FIG. 4 and 5, structure 100 could, alternatively, include a semiconductor substrate 103 (e.g., monocrystalline silicon substrate or a monocrystalline substrate of some other suitable semiconductor material). Structure 100 could include further include an insulator layer 102 (e.g., a buried oxide (BOX) layer or other suitable insulator layer) immediately adjacent to the top surface of semiconductor substrate 103. Structure 100 could further include a monocrystalline semiconductor layer 106 (e.g., a silicon layer or a layer of some other suitable monocrystalline semiconductor material) on insulator layer 102. Semiconductor layer 106 can, for example, be relatively thin (e.g., 20nm or less, preferably 4-12nm).

In this case, channel region 113 of transistor 110 can be within semiconductor layer 106 (i.e., above insulator layer 102) and positioned laterally between source region 111 and drain region 112. The multi-layer stack can be on the top surface of semiconductor layer 106. More specifically, as illustrated in FIG. 4, a multi-layer stack 140a (as described in greater detail above and illustrated in FIG. 2) can be on the top surface of semiconductor layer 106 with the first section (S1) on the source region 111 and the second section (S2) (i.e., the gate) on the channel region 113. Alternatively, as illustrated in FIG. 5, a multi-layer stack 140b (as described in greater detail above and illustrated in FIG. 3) can be on the top surface of semiconductor layer 106 with the first section (S1) on the source region 111 and the second section (S2) (i.e., the gate) on the channel region 113.

Optionally, transistor 110 as shown in FIGs. 4 and 5 can be a fully-depleted semiconductor-on-insulator (e.g., fully-depleted silicon-on-insulator (FDSOI) transistor) or a partially-depleted semiconductor-on-insulator (e.g., partially-depleted silicon-on-insulator (PDSOI) transistor). Those skilled in the art will recognize that one advantage of FDSOI processing technology platforms or the like is that processing can be performed to ensure that a transistor has a specific type of threshold voltage (VT). For example, a transistor can be formed on the insulator layer above a well region. A well region refers to a region of semiconductor material doped so as to have a specific type of conductivity. For example, an N-type well region (Nwell) can be doped so as to have N-type conductivity, whereas a P-type well region (Pwell) can be doped so as to P-type conductivity. Depending upon the conductivity type of the transistor and the conductivity type of the well region below, the transistor could be: (a) a super low threshold voltage (SLVT) or low threshold voltage (LVT) transistor; or (b) a regular threshold voltage (RVT) transistor or a high threshold voltage (HVT) transistor. As mentioned above in structure 100, transistor 110 can be an NFET. A SLVT or LVT NFET can be achieved by forming the NFET on an Nwell, whereas an RVT or HVT NFFET can be achieved by forming the NFET over a Pwell. Another advantage of FDSOI processing technology platforms or the like is that some level of back-biasing (e.g., reverse back-biasing (RBB) or forward back-biasing (FBB)) can be employed to fine tune the VT and, thereby achieve a target switching speed.

In structure 100 of FIGs. 4 and 5, portions of insulator layer 102 and well region 104 aligned below channel region 113 effectively function as a back gate 116. Structure 100 can further include a well contact region 107 (also referred to herein as a well tap), which extends through an opening in insulator layer 102, which is electrically isolated from semiconductor layer 106 (e.g., via a shallow trench isolation region), and which is in contact with well region 104. Well contact region 107 can have the same type conductivity as the well region 104, but at a higher conductivity level. Well contact region 107 can be connected to receive a back gate bias voltage to facilitate back-biasing during memory cell 105 operation. Forward back-biasing (FBB) refers specifically to applying a voltage that will reduce the VT of the FET, thereby increasing the switching speed. Generally, for an NFET, FBB is achieved by applying a positive voltage to the back-side of the channel region. Reverse back-biasing (RBB) refers specifically to applying a voltage that will increase the VT of the FET, thereby decreasing the switching speed and reducing leakage current. Generally, for an NFET, RBB is achieved by applying a negative voltage to the back-side of the channel region. Thus, for structure 100 of FIGs. 4 and 5, in addition to applying bias conditions to device terminals through WL, SL, and BL, back gate 116 can also be biased during memory operations to fine tune the VT of transistor 110 and thereby fine tune memory cell 105 performance.

Also disclosed herein are method embodiments for operating structure 100 and, particularly, for operating memory cell 105.

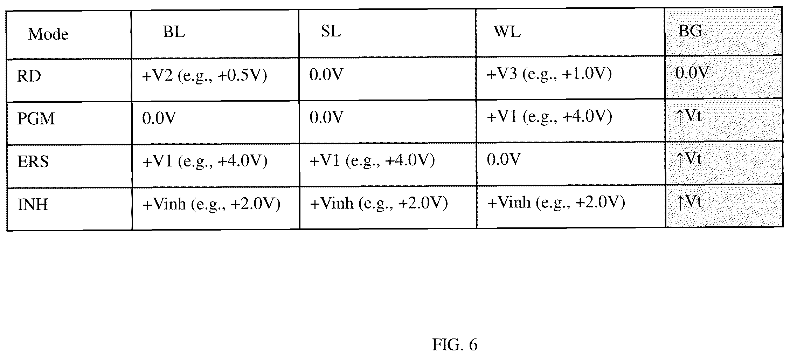

FIG. 6 is a table illustrating an example of a set of operation-dependent bias voltage conditions that can be employed during memory cell operation. In this set, only positive bias voltages or ground are applied to the BL, SL, and WL, as noted below. Memory structure configurations that enable positive bias voltages or ground to be applied to voltage lines during memory operations are known in the art and, thus, the details thereof have been omitted from the specification in order to allow the reader to focus on the salient aspects of the discloses embodiments. Referring to the table of FIG. 6 and the disclosed embodiments of structure 100 (e.g., as illustrated in FIGs. 2, 3, 4 or 5), the method can include performing a write operation and, particularly, a programming operation to store a first logic value (e.g., a "1") within the FEC of S1 of memory cell 105. The programming operation can be performed by: connecting the BL (which is electrically connected to drain region 112 of transistor 110) to ground (i.e., to 0.0 volts (V)); connecting the SL (which is electrically connected to source region 111 of transistor 110) to ground; and applying a word line voltage (VWL) at a first positive voltage level (+V1) (e.g., +V1=+4.0V) to the WL (which is electrically connected to the multi-layer stack 140a or 140b). Optionally, in structure 100 of FIGs. 4 and 5, RBB can be performed by connecting BG to receive a negative back gate voltage (VBG).

This programming operation switches the direction of polarization vector in the FEM in S1 (e.g., in the portion of second insulating layer 152 of FEM in S1 of multilayer stack 140a shown in FIGs. 2 and 4 or in the third insulating layer 153 of FEM in S1 of multi-layer stack 140b shown in FIGs. 3 and 5) to point toward source region 111 for storing a first logic value (e.g., a "1"). As mentioned above, S1 does not include the first insulating layer 151 (i.e., the IF layer). Thus, the direction of polarization switching during programming of the FEC can be achieved with a relatively low positive voltage on the WL (VWL) as compared to the relatively high positive VWL used in a conventional FEFET programming operations. For example, a VWL of only +4.0V or less could be used for programming the FEC of memory cell 105 as opposed to a VWL of, for example, +6.0V or more, which may be required for programming a conventional FEFET memory cell.

Referring specifically to the multi-layer stack 140a of structure 100 of FIGs. 2 and 4, VWL for programming can be tuned to ensure that direction of polarization switching only occurs within the portion of FEM (i.e., second insulating layer 152) within S1 and not in S2. Furthermore, it should be noted that in this programming operation with a +V1 on gate 115, transistor 110 (which is an NFET) will be placed in inversion, allowing current to flow between source and drain regions 111-112. As a result, a first total capacitance area defined by the second insulating layer 152 between substrate 101 (which is conductive through channel region 113) and second metallic layer 162 will be equal to a second total capacitance area defined by the third insulating layer 153 between the second metallic layer 162 (which is floating) and the third metallic layer 163 (which is positively biased). Thus, during the programming operation, the capacitor area ratio in multi-layer stack 140a is neutral.

Referring specifically to the multi-layer stack 140b of structure 100 of FIGs. 3 and 5, it should be noted that in this programming operation with a +V1 on gate 115, transistor 110 (which is an NFET) will similarly be in inversion, allowing current to flow between source and drain regions 111-112. As a result, a first total capacitance area defined by the second insulating layer 152 between substrate 101 (which is conductive through channel region 113) and second metallic layer 162 will be greater than a second total capacitance area defined by the third insulating layer 153 (which is only within S1) between the second metallic layer 162 (which is floating) and the third metallic layer 163 (which is positively biased). Thus, during the programming operation, the capacitor area ratio in multi-layer stack 140b is beneficial. Specifically, the relatively small total capacitance area associated with the third insulating layer 153 (i.e., the FEM layer in the embodiments shown in FIGs. 3 and 5) of the FEC relative to the total capacitance area associated with the second insulating layer 152 (which is non-ferroelectric in the embodiments shown in FIGs. 3 and 5) will be beneficial since the voltage divider during write operation shifts towards the FEC. To switch the direction of polarization in the third insulating layer 153 (i.e., FEM layer), the voltage drop is required to be high in the third insulating layer 153 and low in the second insulating layer 152 to prevent parasitic charge trapping which eventually loads the floating metallic node (i.e., the second metallic layer 162) with unwanted charges. Furthermore, the ferroelectric memory window is enhanced when the FEC has a relatively small total capacitance area as compared to the total capacitance area associated with the second insulating layer 152.

The method can also include performing a different write operation and, particularly, an erasing operation to store a second logic value (e.g., a "0") within the FEC of S1 of memory cell 105. The erasing operation can be performed by: applying a bit line voltage (VBL) at +V1 to the BL; applying a source line voltage (VSL) at +V1 to the SL; and connecting the WL to ground. Optionally, in structure 100 of FIGs. 4 and 5, RBB can be performed by connecting BG to receive a negative back gate voltage (VBG).

This erasing operation switches the direction of polarization vector in the FEM in S1 (e.g., in the portion of second insulating layer 152 of FEM in S1 of multilayer stack 140a shown in FIGs. 2 and 4 or in the third insulating layer 153 of FEM in S1 of multi-layer stack 140b shown in FIGs. 3 and 5) to point in the opposite direction toward WL for storing a second logic value (e.g., a "0"). It should be noted that because S1 does not include the first insulating layer 151 (i.e., the IF layer) lower positive bit line and source line voltages (VBL and VSL) (e.g., by up to half) may be needed to achieve direction of polarization switching during erasing compared to the relatively high VBL and VSL used when erasing a conventional FEFET. For example, a VBL and a VSL of +4.0V or less may be used for erasing the FEC of memory cell 105 as opposed to a VBL and a VSL of, for example, +6.0V or more that may be required for erasing a conventional FEFET memory cell.

Referring specifically to the multi-layer stack 140a of structure 100 of FIGs. 2 and 4, VBL and VSL for erasing can be tuned to ensure that direction of polarization switching only occurs within the portion of FEM (i.e., second insulating layer 152) within S1 and not in S2. Furthermore, it should be noted that in this erasing operation with 0.0 V on gate 115, transistor 110 (which is an NFET) will be placed in accumulation, blocking current from flowing between source and drain regions 111-112. As a result, a first total capacitance area defined by the second insulating layer 152 between substrate 101 (which is not conductive through channel region 113) and second metallic layer 162 will be smaller than a second total capacitance area defined by the third insulating layer 153 between the second metallic layer 162 (which is floating) and the third metallic layer 163 (which is positively biased). Thus, during the erasing operation, the capacitor area ratio in multi-layer stack 140a is beneficial. Specifically, the relatively small total capacitance area associated with the second insulating layer 152 (i.e., the FEM layer in the embodiments shown in FIGs. 2 and 4) of the FEC relative to the total capacitance area associated with the third insulating layer 153 (which is non-ferroelectric in the embodiments shown in FIGs. 2 and 4) will be beneficial since the voltage divider during write operation shifts towards the FEC. To switch the direction of polarization in the portion of the second insulating layer 152 (i.e., the portion of FEM layer) within S1, the voltage drop is required to be high in the second insulating layer 152 and low in the third insulating layer 153 to prevent parasitic charge trapping which eventually loads the floating metallic node (i.e., the second metallic layer 162) with unwanted charges. Furthermore, the ferroelectric memory window is enhanced when the FEC has a relatively small total capacitance area as compared to the total capacitance area associated with the third insulating layer 153.

Referring specifically to the multi-layer stack 140b of structure 100 of FIGs. 3 and 5, it should be noted that in this erasing operation with 0.0 V on gate 115, transistor 110 (which is an NFET) will similarly be in accumulation, blocking current from flowing between source and drain regions 111-112. As a result, a first total capacitance area defined by the second insulating layer 152 between substrate 101 (which is non-conductive through channel region 113) and second metallic layer 162 will be the same as a second total capacitance area defined by the third insulating layer 153 (which is only within S1) between the second metallic layer 162 (which is floating) and the third metallic layer 163 (which is positively biased). Thus, during the erasing operation, the capacitor area ratio in multi-layer stack 140b is neutral.

As mentioned above, transistor 110 (which is an NFET) is in inversion during the programming operation and in accumulation during the erasing operation. Therefore, a parasitic voltage drop across transistor 110 only occurs during the programming operation and not during the erasing operation. However, since IF layer degradation is known in the art to be a bipolar stress issue and since the IF layer 151 in transistor 110 of memory cell 105 is only exposed to unipolar stress (i.e., only during the programming operation), memory cell 105 is more robust than conventional FEFET memory cells and may exhibit relatively long endurance. For example, it may be able to undergo over 1*10¹² write cycles or more without failure.

The method can also include performing a read operation to read out the stored data from the FEC of S1 of memory cell 105. The read operation can be performed by: applying a VBL at a second positive voltage level (+V2) that is less than +V1 (e.g., +V2=+0.5V) to the BL; connecting the SL to ground; and applying a VWL at a third positive voltage level (+V3) that is between +V1 and +V2 (e.g., +V3= 1.0V) to the WL. During the read, BG can be connected to ground. During the read operation, the floating metallic node (i.e., the second metallic layer 162 that extends through both S1 and S2 and that forms one plate of the FEC in S2) can be employed to sense the state of the FEC. For example, if the FEC has been programmed, transistor 110 will have a relatively low threshold voltage (LVT) and current will flow from source region 111 to drain region 112 so that a change in an electrical parameter (e.g., current or voltage) is detectable on the BL. As mentioned above, this can indicate a first logic value (e.g., "1") stored in the FEC. However, if the FEC has been erased, transistor 110 will have a relatively high threshold voltage (HVT) and current flow from the source region 111 to drain region 112 will be inhibited so that a change in the electrical parameter (e.g., current or voltage) is not detectable on the BL. As mentioned above, this can indicate a second logic value (e.g., "0") stored in the FEC.

Finally, the method can also include establishing biasing conditions that would inhibit stored data flipping when write and read operations are not being performed in memory cell 105 (e.g., when write or read operations are being perform in other memory cells within the same array). Inhibit conditions can include, for example: applying a VBL at a positive inhibit voltage level (+Vinh) that is between +V1 and +V3 (e.g., +Vinh=+2.0V) to the BL; applying a VSL at +Vinh to SL; and applying a VWL at +Vinh to the WL. Optionally, in the structure 100 of FIGs. 4 and 5, RBB can be performed by connecting BG to receive a negative back gate voltage (VBG).

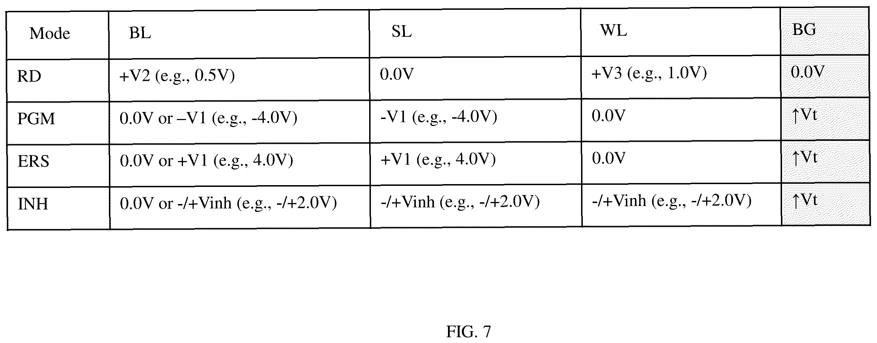

FIG. 7 is a table illustrating another example of a set of operation-dependent bias voltage conditions that can be employed during memory cell operation. In this set, positive bias voltages, negative bias voltages, or ground can be applied to the BL, SL, and WL, as noted below. Memory structure configurations that enable both positive and negative bias voltage to be applied to voltage lines during memory operations are known in the art and, thus, the details thereof have been omitted from the specification in order to allow the reader to focus on the salient aspects of the disclosed embodiments. Referring to the table of FIG. 7 and the disclosed embodiments of structure 100 (e.g., as illustrated in FIGs. 2, 3, 4 or 5), the method can include performing a write operation and, particularly, a programming operation to store a first logic value (e.g., a "1") within the FEC of S1 of memory cell 105. The programming operation can be performed by: connecting the BL to ground (i.e., to 0.0 volts (V)) or applying a VBL at a first negative voltage level (-V1) (e.g., -V1=-4.0V) to the BL; applying a VSL at -V1 to the SL; and connecting the WL to ground. Optionally, in structure 100 of FIGs. 4 and 5, RBB can be performed by connecting BG to receive a negative back gate voltage (VBG).

The method can also include performing a different write operation and, particularly, an erasing operation to store a second logic value (e.g., a "0") within the FEC of S1 of memory cell 105. The erasing operation can be performed by: connecting the BL to ground or applying a VBL at a first positive voltage level (+V1) (e.g., +V1=4.0V) to the BL; applying a VSL at +V1 to the SL; and connecting the WL to ground. Optionally, in structure 100 of FIGs. 4 and 5, RBB can be performed by connecting BG to receive a negative back gate voltage (VBG).

The method can also include performing a read operation to read out the stored data from the FEC of S1 of memory cell 105. The read operation can be performed by: applying a VBL at a second positive voltage level (+V2) that is less than +V1 (e.g., +V2=+0.5V) to the BL; connecting the SL to ground; and applying a VWL at a third positive voltage level (+V3) that is between +V1 and +V2 (e.g., +V3= +1.0V) to the WL. During the read, BG can be connected to ground.

Finally, the method can also include establishing biasing conditions that would inhibit stored data flipping when other memory operations are not being performed. Inhibit conditions can include: applying a VBL at a positive or negative in inhibit voltage level (-/+Vinh) (e.g., -/+Vinh=-/+2.0V) to the BL; applying a VSL at -/+Vinh to SL; and applying a VWL at -/+Vinh to the WL. Optionally, in structure 100 of FIGs. 4 and 5, RBB can be performed by connecting BG to receive a negative back gate voltage (VBG).

Memory structure configurations with a bipolar voltage source and, particularly, memory structure configurations that enable a combination of different positive and negative bias voltages to be applied to the BL, SL, and WL during memory operations as discussed above can be complex and costly. However, by using a bipolar voltage source and the biasing voltages set forth in the table of FIG. 7, programming and erasing operations in the disclose memory cell 105 could be performed via WL to SL only. As a result, the voltage drop across the read transistor can be fully inhibited (as opposed to only being inhibited during erasing operations when using the set of operation-dependent bias voltage conditions set forth in FIG. 6) for even longer endurance.

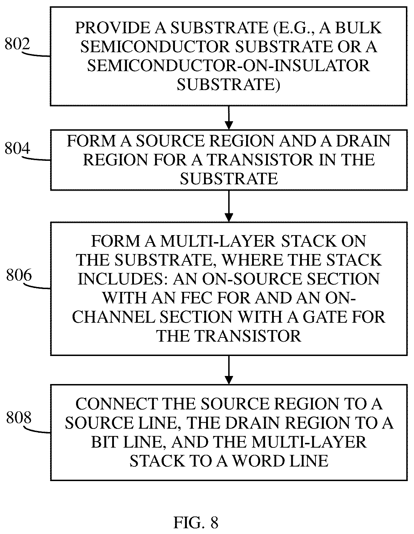

Referring to the flow diagram of FIG. 8, also disclosed herein are embodiments of a method for forming the disclosed structure 100 (e.g., as shown in FIGs. 2, 3, 4 or 5).

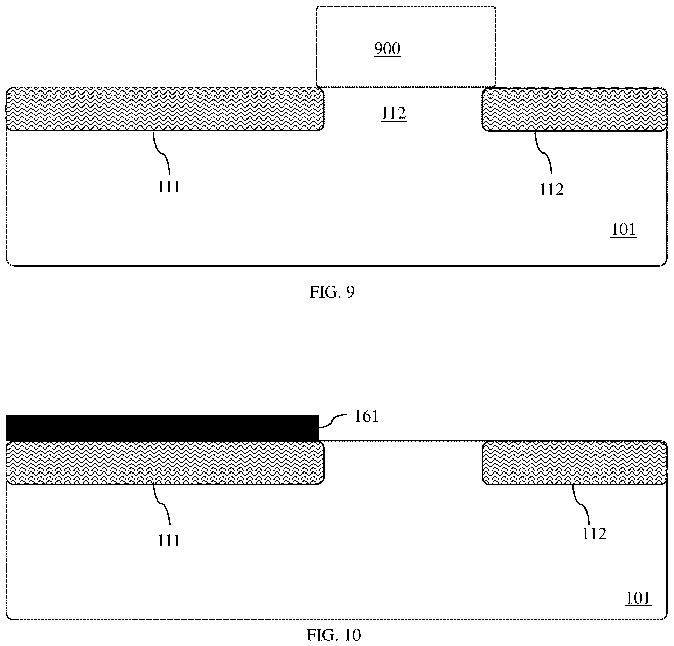

The method can include providing a substrate (see process 802 and FIG. 9). The substrate can be a bulk semiconductor substrate 101 as described in detail above and illustrated in FIGs. 2 and 3. Alternatively, the substrate could be a semiconductor-on-insulator substrate as described in detail above and illustrated in FIGs. 4 and 5. For purposes of illustration, the method is described in greater detail below as being formed using a bulk semiconductor substrate 101. It should be understood that these same processes can be employed when using a semiconductor-on-insulator substrate. Furthermore, it should be understood that any features of the structure of FIGs. 4 and 5 that are not shown in the structures of FIGs. 2 and 3, and that are employed to facilitate back biasing (e.g., the well region 104 and well contact region 107), are known in the art and can be formed using conventional techniques used, for example, in FDSOI processing.

The method can further include forming a source region 111 and a drain region 112 for a transistor at the top surface of semiconductor substrate 101, where the source region 111 and drain region 112 are separated by a channel region 113 (see process 804 and FIG. 9). For example, the semiconductor substrate 101 can be doped so as to have P-type conductivity at a relatively low conductivity level (e.g., so as to be a P- substrate). A mask 900 can be formed on top surface of semiconductor substrate 101 and patterned with a pair of openings exposing desired locations for source region 111 and drain region 112. Optionally, the opening for source region 111 can be relatively long compared to opening for the drain region 112. Next, a dopant implantation process can be performed to implant an N-type dopant through the openings and into the semiconductor substrate below, thereby forming source region 111 and drain region 112. The dopant implantation process can be performed so that the source and drain regions 111-112 have N-type conductivity at a relatively high conductivity level (e.g., so that they are N+ source and drain regions). Mask 900 can then be removed.

Following source/drain formation, a multi-layer stack (e.g., the multi-layer stack 140a of FIGs. 2 and 4 or the multi-layer stack 140b of FIGs. 3 and 5) can be formed on the top surface of the semiconductor substrate 101 such that it includes: a first section (S1), which is on source region 111 and which includes a ferroelectric capacitor (FEC), and a second section (S2), which is on channel region 113 extending laterally between source region 111 and drain region 112, which is different from S1, and which includes a gate for the transistor (see process 806).

To form the multi-layer stack 140a or 140b, a first metallic layer 161 can be formed on the top surface of semiconductor substrate 101 immediately adjacent to source region 111. The material(s) of the first metallic layer 161 can specifically be selected to form an ohmic contact at the metal-semiconductor junction. Thus, the first metallic layer 161 can, for example, be a metal layer (e.g., tungsten, titanium, tantalum, etc.) or a metal alloy layer (e.g., a metal nitride, such as titanium nitride or tantalum nitride, or a metal silicide, such as nickel silicide, tungsten silicide, or some other suitable metal silicide). Alternatively, first metallic layer 161 could be formed as a multi-metallic layer stack suitable for creation of an ohmic contact (e.g., titanium/aluminum/titanium nitride, titanium/aluminum/titanium/gold, or molybdenum/aluminum/molybdenum/gold). First metallic layer 161 can further be patterned (e.g., using conventional lithographic patterning and etch techniques or any other suitable patterning technique) so as to expose at least channel region 113 and drain region 112 (see FIG. 10).

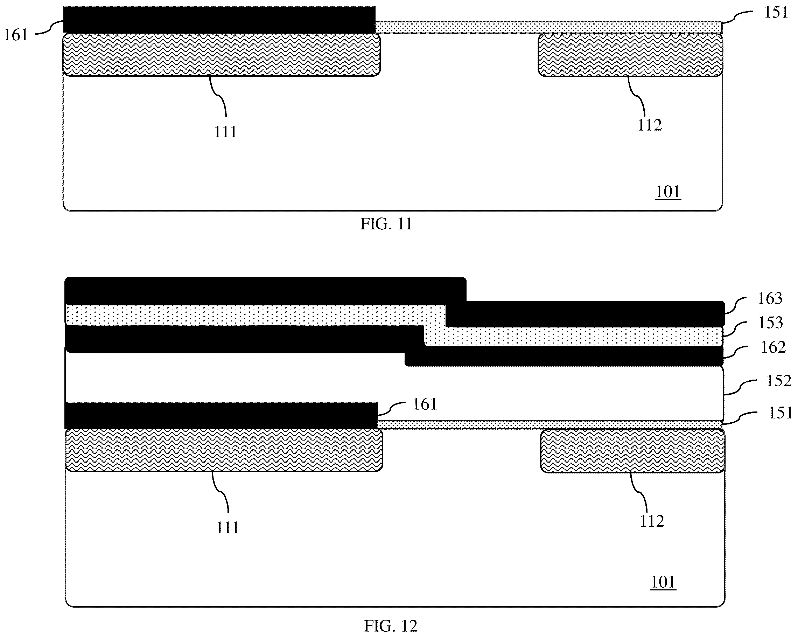

Following formation of first metallic layer 161, a first insulating layer 151 can be formed (e.g., through a controlled oxide or oxynitride-on silicon growth process or a native oxide-on silicon growth process due to exposure to an oxygen-rich environment) and patterned (e.g., using conventional lithographic patterning and etch techniques or any other suitable patterning technique) so that the first metallic layer 161 is exposed and so that the first insulating layer is positioned laterally adjacent to first metallic layer 161 (e.g., covering channel region 113 and, optionally, extending over drain region 112) (see FIG. 11). Optionally, first insulating layer 151 can be formed so that it is relatively thin compared to first metallic layer 161. First insulating layer 151 can be an insulating interface (IF) layer. Insulating IF layer can, for example, include a silicon dioxide or another dielectric material with a dielectric constant (K) that is approximately equal to or below the dielectric constant of silicon dioxide (e.g., a dielectric material where K≤3.9).

To form multi-layer stack 140a of FIGs. 2 and 4, multiple additional layers can be formed over the partially completed structure (see FIG. 12). Specifically, a second insulating layer 152 can be formed over first metallic layer 161 and first insulating layer 151. This second insulating layer 152 can be a relatively thick ferroelectric material (FEM) layer (e.g., a hafnium oxide-based FEM layer, such as a silicon-doped hafnium oxide layer or a hafnium zirconium oxide layer, or a layer of some other suitable FEM capable of switching polarity in response to an applied electric field). A second metallic layer 162 can be formed over the second insulating layer 152. The second metallic layer 162 can be, for example, a metal layer (e.g., tungsten, titanium, tantalum, etc.) or a metal alloy layer (e.g., a metal nitride, such as titanium nitride or tantalum nitride). A third insulating layer 153 can be formed over the second metallic layer 162 within S1 and S2. Third insulating layer 153 can specifically be a layer of high-K dielectric material (i.e., a dielectric material where K>3.9, and ideally where K>7 or even higher, such as K>20) that is not ferroelectric. Exemplary high-K dielectric materials include, but are not limited to, silicon nitride, silicon oxynitride, alumina, and non-ferroelectric hafnium oxide. Those skilled in the art will recognize that the ferroelectric properties of hafnium oxide films can depend, for example, on the polymorphic phase of the material and/or material doping. Finally, a third metallic layer 163 can be formed over the third insulating layer 153. Third metallic layer 163 can be, for example, a metal layer (e.g., tungsten, titanium, tantalum, etc.) or a metal alloy layer (e.g., a metal nitride, such as titanium nitride or tantalum nitride). It should be noted that in multi-layer stack 140a the first, second, and third metallic layers 161-163 can all be made of the same metal or metal alloy material or two or more of the metallic layers 161-163 can be made of different metal or metal alloy materials.

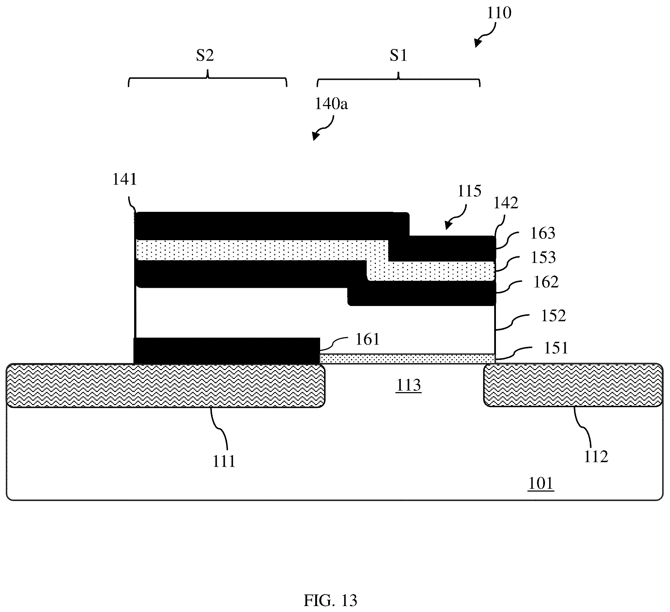

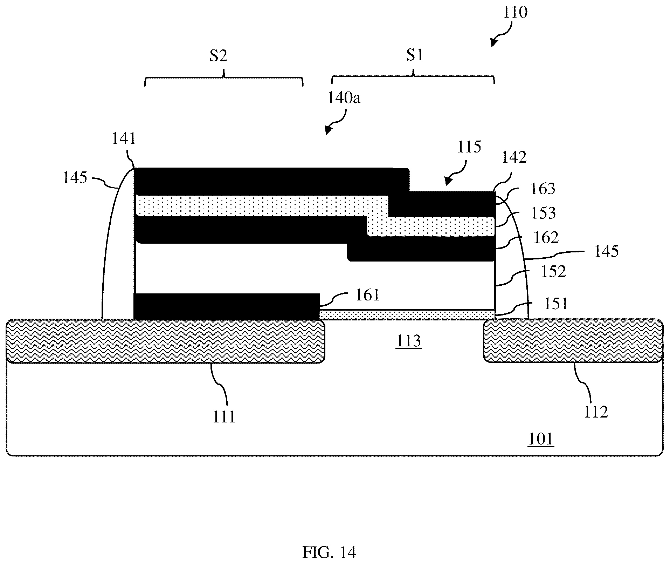

The metallic and insulating layers can then be patterned (e.g., using conventional lithographic patterning and etch techniques) to complete the multi-layer stack 140a (see FIG. 13). Such patterning can be performed so that the resulting multi-layer stack 140a includes layers 161, 152, 162, 153, and 163 in a first section (S1) on source region 111 and layers 151, 152, 162, 153, and 163 in a second section (S2) on the channel region 113. Such patterning can also be performed such that the resulting multi-layer stack 140a has a first sidewall 141 above the source region 111 distal to the junction between the source region 111 and the channel region 113 and a second sidewall 142 above the drain region 112 proximal to the junction between the drain region 112 and the channel region 113. Dielectric sidewall spacer 145 can then be formed on the first and second sidewalls 141-142 of multi-layer stack 140a (see FIG. 14). For example, a conformal dielectric layer (e.g., a silicon dioxide layer or a layer of some other suitable dielectric sidewall spacer material) can be deposited over the partially completed structure. Next, an anisotropic etch process can be performed to remove the spacer material from horizontal surfaces, leaving it intact as sidewall spacers on vertical surface.

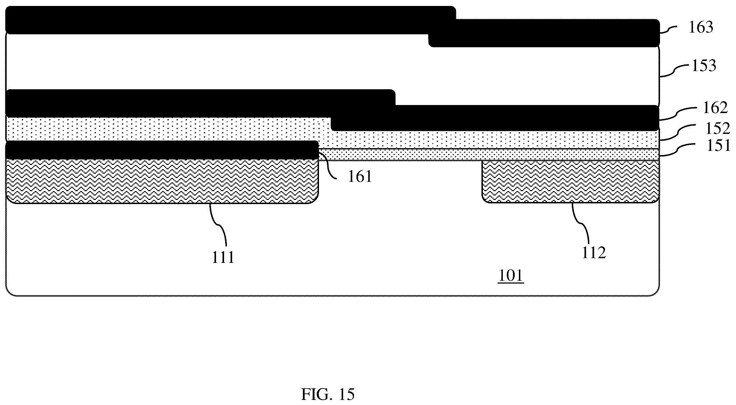

To form multi-layer stack 140b of FIGs. 3 and 5, multiple additional layers can be formed over the partially completed structure (see FIG. 15). In this case, a second insulating layer 152 can be formed on first metallic layer 161 and on first insulating layer 151. In the multi-layer stack 140b, the second insulating layer can be a layer of high-K dielectric material (e.g., silicon nitride, silicon oxynitride, alumina, non-ferroelectric hafnium oxide, etc.). A second metallic layer 162 can be formed on second insulating layer 152. Second metallic layer 162 can be, for example, a metal layer (e.g., tungsten, titanium, tantalum, etc.) or a metal alloy layer (e.g., a metal nitride, such as titanium nitride or tantalum nitride). A third insulating layer 153 can be formed on the second metallic layer 162. In the multi-layer stack 140b, the third insulating layer 153 can specifically be a relatively thick FEM layer (e.g., a hafnium oxide-based FEM layer, such as a silicon-doped hafnium oxide layer or a hafnium zirconium oxide layer, or a layer of some other suitable FEM capable of switching polarity in response to an applied electric field). Finally, a third metallic layer 163 can be formed over the third insulating layer 153. Third metallic layer 163 can be, for example, a metal layer (e.g., tungsten, titanium, tantalum, etc.) or a metal alloy layer (e.g., a metal nitride, such as titanium nitride or tantalum nitride). It should be noted that in multi-layer stack 140b the first, second, and third metallic layers 161-163 can all be made of the same metal or metal alloy material or two or more of the metallic layers 161-163 can be made of different metal or metal alloy materials.

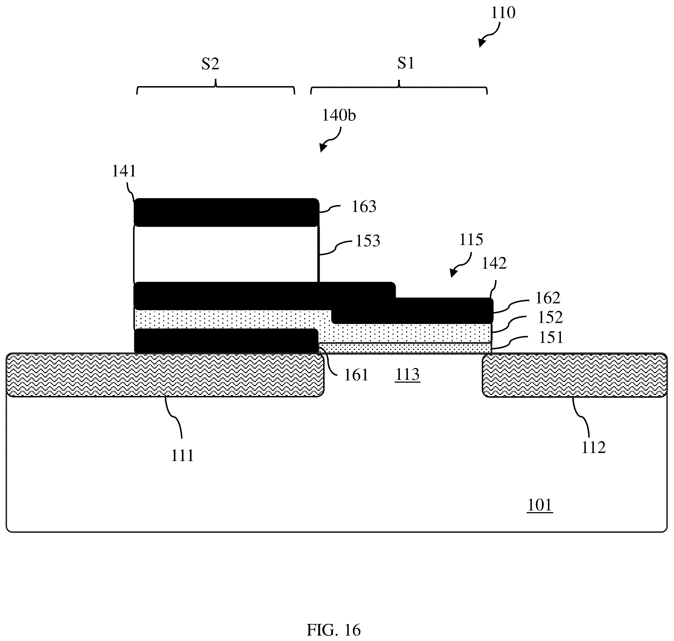

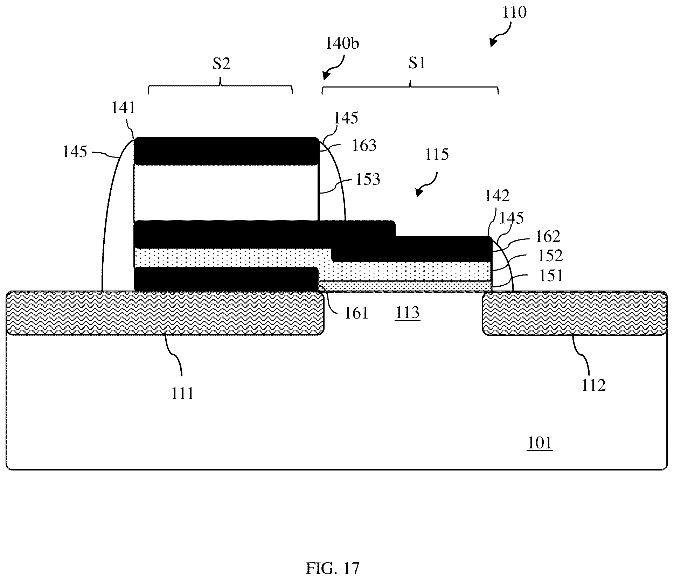

The metallic and insulating layers can then be patterned (e.g., using conventional lithographic patterning and etch techniques) to complete the multi-layer stack 140b (see FIG. 16). Such patterning can be performed in multiple steps (e.g., two sets of lithographic patterning and etch processes) so that the resulting multi-layer stack 140b includes layers 161, 152, 162, 153, and 163 in a first section (S1) on source region 111, and includes only layers 151, 152, and 162 in second section (S2) on the channel region 113. Such patterning can also be performed such that the resulting multi-layer stack 140b has a first sidewall 141 above the source region 111 distal to the junction between the source region 111 and the channel region 113 and a second sidewall 142 above the drain region 112 proximal to the junction between the drain region 112 and the channel region 113. Dielectric sidewall spacer 145 can then be formed on the first and second sidewalls 141-142 of multi-layer stack 140b (see FIG. 17). For example, a conformal dielectric layer (e.g., a silicon dioxide layer or a layer of some other suitable dielectric sidewall spacer material) can be deposited over the partially completed structure. Next, an anisotropic etch process can be performed to remove the spacer material from horizontal surfaces, leaving it intact as sidewall spacers on vertical surface.

In the method embodiments described above processing includes the formation of both metallic layers and insulating layers. Techniques for forming such thin film metallic and insulating layer (e.g., chemical vapor deposition, physical vapor deposition, etc.) are known in the art. Thus, the details thereof have been omitted form the specification in order to allow the reader to focus on the salient aspects of the disclosed method embodiments (e.g., related to patterning to achieve the above-described multi-layer stack 140a of FIGs. 5 and 7 or 140b of FIGs. 6 and 8). However, those skilled in the art will recognize that the preferred deposition technique can vary depending upon the type of material, thickness of the material, underlying material, desired physical properties of the material, etc.

Additional processing to form structure 100 of FIGs. 2-5 can include, but is not limited to, middle of the line (MOL) processing and back end of the line (BEOL) processing (see process 808). MOL processing can include, for example, formation of one or more layers of interlayer dielectric (ILD) material over transistor 110 and formation of MOL contacts, which extend through the ILD material to transistor 110 (e.g., to source region 111, drain region 112, and to third metallic layer 163 of multi-layer stack 140a or 140b). BEOL processing can include formation of interconnects (including wires and vias) in metal levels above the MOL contacts in order to electrically connect a SL, a BL, and a WL of a memory structure to source region 111, drain region 112, and multi-layer stack 140a or 140b, respectively.

It should be understood that in the method and structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a memory cell is disclosed which, in various embodiments, includes a transistor with a channel region in a substrate between source and drain regions. A multi-layer stack on the substrate includes: a first section (including a ferroelectric capacitor (FEC)) adjacent the source region and a second section (including the transistor gate) adjacent the channel region. Specifically, the multi-layer stack includes: a first metallic layer on the source region in the first section; a first insulating layer on the channel region in the second section; a second insulating layer on the first metallic layer and the first insulating layer; and a second metallic layer on the second insulating layer. In some embodiments, the second insulating layer is FE material and the multi-layer stack also includes third insulating and metallic layers on the second metallic layer in the first and second sections. Also disclosed are methods for operating and for forming the memory cell.

The following embodiments are explicitly disclosed.

### Embodiment 1:

A structure comprising:
a transistor including: a source region; a drain region; and a channel region between the source region and the drain region; and
a multi-layer stack including:
   a first metallic layer on the source region;
   a first insulating layer on the channel region;
   a second insulating layer on the first metallic layer and on the first insulating layer; and
   a second metallic layer on the second insulating layer.

### Embodiment 2:

The structure of embodiment 1, wherein the first metallic layer is any of a metal layer, a metal alloy layer, and a metal silicide layer.

### Embodiment 3:

The structure of embodiment 1 or 2, wherein the first insulating layer is different from the second insulating layer.

### Embodiment 4:

The structure of one of embodiments 1 to 3, wherein the first insulating layer is silicon dioxide. Furthermore, the second insulating layer may be at least one of a ferroelectric material layer and a dielectric layer with a higher dielectric constant than the silicon dioxide.

### Embodiment 5:

The structure of one of embodiments 1 to 4, wherein the multi-layer stack has a first section on the source region and a second section on the channel region, and wherein the multi-layer stack includes
the first metallic layer in the first section;
the first insulating layer in the second section;
the second insulating layer on the first metallic layer in the first section and on the first insulating layer in the second section, wherein the second insulating layer includes a ferroelectric material layer;
the second metallic layer on the second insulating layer in the first section and in the second section;
a third insulating layer on the second metallic layer in the first section and in the second section; and
a third metallic layer on the third insulating layer in the first section and in the second section.

### Embodiment 6:

The structure of embodiment 5, wherein the third metallic layer is electrically connected to a word line, the source region is electrically connected to a source line, and the drain region is electrically connected to a bit line.

### Embodiment 7:

The structure of embodiment 6,
wherein the second section includes a gate of the transistor adjacent to the channel region and electrically connected to the word line,
wherein the first section include series capacitors electrically connected to the source region and to the word line, and
wherein one of the series capacitors is a ferroelectric capacitor.

### Embodiment 8:

The structure of one of embodiments 1 to 7, further comprising:
a semiconductor substrate;
a well region in the semiconductor substrate;
an insulator layer on the semiconductor substrate adjacent to the well region; and
a semiconductor layer having a first surface adjacent to the insulator layer and a second surface opposite the first surface,
wherein the channel region, the source region, and the drain region are within the semiconductor layer,
wherein the first metallic layer and the first insulating layer are immediately adjacent to the source region and the channel region, respectively, on the second surface,
wherein the transistor further includes a back gate including portions of the insulator layer and the well region adjacent to the channel region, and
wherein the well region is connected to receive a back gate bias voltage.

### Embodiment 9:

The structure of one of embodiments 1 to 8, further comprising a bulk semiconductor substrate having a first surface and a second surface opposite the first surface, wherein the channel region, the source region, and the drain region are within the semiconductor substrate at the second surface and wherein the first metallic layer and the first insulating layer are immediately adjacent to the source region and the channel region, respectively, on the second surface.

In a combination of embodiment 9 with embodiment 8, the semiconductor substrate of embodiment 8 may be understood as representing a bulk semiconductor substrate, e.g., the bulk semiconductor substrate of embodiment 9.

### Embodiment 10:

The structure of one of embodiments 1 to 9, wherein the multi-layer stack has a first section on the source region and a second section on the channel region;
wherein the first metallic layer is on the source region in the first section;
wherein the first insulating layer is on the channel region in the second section;
wherein the second insulating layer is on the first metallic layer in the first section and on the first insulating layer in the second section;
wherein the second metallic layer is on the second insulating layer in the first section and the second section; and
wherein multi-layer stack further includes:
   a third insulating layer on the second metallic layer in the first section; and
   a third metallic layer on the third insulating layer in the first section,
   wherein the third insulating layer includes a ferroelectric material layer, and
   wherein the second section is devoid of the third insulating layer and the third metallic layer.

### Embodiment 11:

A structure comprising:
a transistor including: a source region; a drain region; and a channel region between the source region and the drain region; and
a multi-layer stack having a first section on the source region and a second section on the channel region, wherein the multi-layer stack includes:
   a first metallic layer on the source region in the first section;
   a first insulating layer on the channel region in the second section;
   a second insulating layer on the first metallic layer in the first section and on the first insulating layer in the second section;
   a second metallic layer on the second insulating layer in the first section and the second section;
   a third insulating layer on the second metallic layer in the first section; and
   a third metallic layer on the third insulating layer in the first section, wherein the third insulating layer includes a ferroelectric material layer and wherein the second
section is devoid of the third insulating layer and the third metallic layer.

Embodiment 11 may be understood as being made dependent on embodiments 1 to 9 in the reformulation of embodiment 10.

### Embodiment 12:

The structure of embodiment 10 or 11, wherein the first metallic layer is any of a metal layer, a metal alloy layer, and a metal silicide layer and wherein the first insulating layer is different from the second insulating layer.

### Embodiment 13:

The structure of one of embodiments 10 to 12, wherein the first insulating layer is silicon dioxide and the second insulating layer is a dielectric layer with a higher dielectric constant than the silicon dioxide. Alternatively, the second insulating layer may be a ferroelectric material layer.

### Embodiment 14:

The structure of one of embodiments 10 to13, wherein the third metallic layer is electrically connected to a word line, the source region is electrically connected to a source line, and the drain region is electrically connected to a bit line.

### Embodiment 15:

The structure of embodiment 14,
wherein the second section includes a gate of the transistor adjacent to the channel region,
wherein the first section include series capacitors electrically connected to the source region and to the word line, and
wherein one of the series capacitors is a ferroelectric capacitor.

### Embodiment 16:

The structure of one of embodiments 10 to 15, further comprising:
a semiconductor substrate;
a well region in the semiconductor substrate;
an insulator layer on the semiconductor substrate adjacent to the well region; and
a semiconductor layer having a first surface adjacent to the insulator layer and a second surface opposite the first surface,
wherein the channel region, the source region, and the drain region are within the semiconductor layer,
wherein the first metallic layer and the first insulating layer are immediately adjacent to the source region and the channel region, respectively, on the second surface,
wherein the transistor further includes a back gate including portions of the insulator layer and the well region adjacent to the channel region, and
wherein the well region is connected to receive a back gate bias voltage.

### Embodiment 17:

The structure of one of embodiments 10 to 16, further comprising a bulk semiconductor substrate having a first surface and a second surface opposite the first surface, wherein the channel region, the source region, and the drain region are within the bulk semiconductor substrate at the second surface and wherein the first metallic layer and the first insulating layer are immediately adjacent to the source region and the channel region, respectively, on the second surface.

### Embodiment 18:

A method, comprising:
forming, for a transistor, a source region, a drain region, and a channel region between the source region and the drain region; and
forming a multi-layer stack with a first section on the source region and a second section on the channel region, wherein the forming of the multi-layer stack includes:
   forming and patterning a first metallic layer and a first insulating layer so the first metallic layer is on the source region in the first section and the first insulating layer is on the channel region in the second section;
   forming a second insulating layer on the first metallic layer; and
   forming a second metallic layer on the second insulating layer.

### Embodiment 19:

The method of embodiment 18,
wherein the second insulating layer includes a ferroelectric material layer, and
wherein the forming of the multi-layer stack further includes:
   forming a third insulating layer on the second metallic layer;
   forming a third metallic layer on the third insulating layer; and
   patterning the multi-layer stack so that:
      the first section includes the first metallic layer, a first portion of the second insulating layer, a first portion of the second metallic layer, a first portion of the third insulating layer, and a first portion the third metallic layer; and
      the second section includes the first insulating layer, a second portion of the second insulating layer, a second portion of the second metallic layer, a second portion of the third insulating layer, and a second portion of the third metallic layer.

### Embodiment 20:

The method of embodiment 18 or 19, wherein the forming of the multi-layer stack further includes
forming a third insulating layer on the second metallic layer, wherein the third insulating layer includes a ferroelectric material layer;
forming a third metallic layer on the third insulating layer; and
performing a multi-step patterning process so that:
   the first section includes, stacked on the source region, the first metallic layer, a first portion of the second insulating layer, a first portion of the second metallic layer, the third insulating layer, and the third metallic layer; and
   the second section includes, stacked on the channel region, the first insulating layer, a second portion of the second insulating layer, and a second portion of the second metallic layer.

### Embodiment 21:

The method of one of embodiments 18 to 20, wherein the source region, the drain region, and the channel region are formed in any one of a bulk semiconductor substrate and a semiconductor layer of a semiconductor-on-insulator substrate.

### Embodiment 22.

The method of one of embodiments 18 to 21, wherein the structure of one of embodiments 1 to 17 is formed. Herein, the transistor and multi-layer stack according to at least one of embodiments 1 to 17 are formed.

## Claims

1. A structure comprising:
a transistor including: a source region; a drain region; and a channel region between the source region and the drain region; and
a multi-layer stack including:
a first metallic layer on the source region;
a first insulating layer on the channel region;
a second insulating layer on the first metallic layer and on the first insulating layer; and
a second metallic layer on the second insulating layer.

2. The structure of claim 1, wherein the first metallic layer is any of a metal layer, a metal alloy layer, and a metal silicide layer.

3. The structure of claim 1 or 2, wherein the first insulating layer is different from the second insulating layer.

4. The structure of one of claims 1 to 3, wherein the first insulating layer is silicon dioxide and the second insulating layer is a ferroelectric material layer.

5. The structure of one of claims 1 to 4, wherein the multi-layer stack has a first section on the source region and a second section on the channel region, and wherein the multi-layer stack includes
the first metallic layer in the first section;
the first insulating layer in the second section;
the second insulating layer on the first metallic layer in the first section and on the first insulating layer in the second section, wherein the second insulating layer includes a ferroelectric material layer;
the second metallic layer on the second insulating layer in the first section and in the second section;
a third insulating layer on the second metallic layer in the first section and in the second section; and
a third metallic layer on the third insulating layer in the first section and in the second section.

6. The structure of claim 5, wherein the third metallic layer is electrically connected to a word line, the source region is electrically connected to a source line, and the drain region is electrically connected to a bit line.

7. The structure of claim 6,
wherein the second section includes a gate of the transistor adjacent to the channel region, and the gate preferably being electrically connected to the word line,
wherein the first section include series capacitors electrically connected to the source region and to the word line, and
wherein one of the series capacitors is a ferroelectric capacitor.

8. The structure of one of claims 1 to 7, further comprising:
a semiconductor substrate;
a well region in the semiconductor substrate;
an insulator layer on the semiconductor substrate adjacent to the well region; and
a semiconductor layer having a first surface adjacent to the insulator layer and a second surface opposite the first surface,
wherein the channel region, the source region, and the drain region are within the semiconductor layer,
wherein the first metallic layer and the first insulating layer are immediately adjacent to the source region and the channel region, respectively, on the second surface,
wherein the transistor further includes a back gate including portions of the insulator layer and the well region adjacent to the channel region, and
wherein the well region is connected to receive a back gate bias voltage.

9. The structure of one of claims 1 to 8, further comprising a bulk semiconductor substrate having a first surface and a second surface opposite the first surface, wherein the channel region, the source region, and the drain region are within the semiconductor substrate at the second surface and wherein the first metallic layer and the first insulating layer are immediately adjacent to the source region and the channel region, respectively, on the second surface.

10. The structure of one of claims 1 to 9, wherein the multi-layer stack has a first section on the source region and a second section on the channel region;
wherein the first metallic layer is on the source region in the first section;
wherein the first insulating layer is on the channel region in the second section; wherein the second insulating layer is on the first metallic layer in the first section and on the first insulating layer in the second section;
wherein the second metallic layer is on the second insulating layer in the first section and the second section; and
wherein multi-layer stack further includes:
a third insulating layer on the second metallic layer in the first section; and
a third metallic layer on the third insulating layer in the first section,
wherein the third insulating layer includes a ferroelectric material layer, and
wherein the second section is devoid of the third insulating layer and the third metallic layer.

11. The structure of claim 10, wherein the first insulating layer is silicon dioxide and the second insulating layer is a dielectric layer with a higher dielectric constant than the silicon dioxide.

12. A method, comprising:
forming, for a transistor, a source region, a drain region, and a channel region between the source region and the drain region; and
forming a multi-layer stack with a first section on the source region and a second section on the channel region, wherein the forming of the multi-layer stack includes:
forming and patterning a first metallic layer and a first insulating layer so the first metallic layer is on the source region in the first section and the first insulating layer is on the channel region in the second section;
forming a second insulating layer on the first metallic layer; and
forming a second metallic layer on the second insulating layer.

13. The method of claim 12,
wherein the second insulating layer includes a ferroelectric material layer, and
wherein the forming of the multi-layer stack further includes:
forming a third insulating layer on the second metallic layer;
forming a third metallic layer on the third insulating layer; and
patterning the multi-layer stack so that:
the first section includes the first metallic layer, a first portion of the second insulating layer, a first portion of the second metallic layer, a first portion of the third insulating layer, and a first portion the third metallic layer; and
the second section includes the first insulating layer, a second portion of the second insulating layer, a second portion of the second metallic layer, a second portion of the third insulating layer, and a second portion of the third metallic layer.

14. The method of claim 12 or 13, wherein the forming of the multi-layer stack further includes
forming a third insulating layer on the second metallic layer, wherein the third insulating layer includes a ferroelectric material layer;
forming a third metallic layer on the third insulating layer; and
performing a multi-step patterning process so that:
the first section includes, stacked on the source region, the first metallic layer, a first portion of the second insulating layer, a first portion of the second metallic layer, the third insulating layer, and the third metallic layer; and
the second section includes, stacked on the channel region, the first insulating layer, a second portion of the second insulating layer, and a second portion of the second metallic layer.

15. The method of one of claims 12 to 14, wherein the source region, the drain region, and the channel region are formed in any one of a bulk semiconductor substrate and a semiconductor layer of a semiconductor-on-insulator substrate.
